# EUROPÄISCHE PATENTSCHRIFT

(11) **EP 0 804 744 B1**
(45) Veröffentlichungstag und Bekanntmachung des Hinweises auf die Patenterteilung: **16.09.1998**
(21) Anmeldenummer: 95940950.9
(22) Anmeldetag: 12.12.1995
(51) Int. Cl.: G01S 7/52, G01S 15/93, G01S 15/02, G01B 7/02, H03K 17/945, H03K 17/955

(54) **VERFAHREN ZUR BERÜHRUNGSLOSEN ABSTANDSMESSUNG**
PROCESS OF NON-CONTACT DISTANCE SENSING
PROCEDE DE TELEMETRIE SANS CONTACT

(30) Priorität: 20.01.1995 DE 19501642
(43) Veröffentlichungstag der Anmeldung: 05.11.1997
(73) Patentinhaber: ROBERT BOSCH GMBH, 70442 Stuttgart (DE)
(72) Erfinder: WEBER, Jens, D-65779 Kelkheim-Fischbach (DE); HOETZEL, Jürgen, D-64720 Michelstadt (DE); TSCHISKALE, Ega, D-64283 Darmstadt (DE)
(86) Internationale Anmeldenummer: DE9501778
(87) Internationale Veröffentlichungsnummer: WO9622548

(56) Entgegenhaltungen:
- FR-A- 2 707 109
- GB-A- 2 266 397

## Beschreibung

Die Erfindung betrifft ein Verfahren zur berührungslosen Abstandsmessung, insbesondere zur Messung des Abstandes von Hindernissen im Nahbereich von Kraftfahrzeugen.

Für Kollisionswarneinrichtungen oder sogenannte Einparkhilfen sind verschiedene Abstandsmeßverfahren bekanntgeworden. So wird beispielsweise in DE 40 23 538 A1 eine Kollisionswarneinrichtung auf Ultraschallbasis beschrieben, bei der mindestens zwei Ultraschallsensoren in einem vorgegebenen Abstand angeordnet sind. Dabei werden Laufzeiten zwischen dem Aussenden jeweils eines Ultraschallsignals und dem Empfangen eines reflektierten Ultraschallsignals des jeweils gleichen und des jeweils anderen Ultraschallsensors gemessen und ausgewertet.

Der Meßbereich von Ultraschallsensoren ist durch den Öffnungswinkel, die Größe des Hindernisses, dessen Reflektionseigenschaften und durch die Detektionsschwelle des Sensors begrenzt. Dadurch ergibt sich einerseits für jeden der Ultraschallsensoren ein "toter Winkel". Zusätzlich kann innerhalb des Fassungswinkels in einem Nahbereich aufgrund der Abklingdauer der Sensoren keine Abstandsmessung durchgeführt werden.

Demgegenüber haben kapazitive Sensoren den Vorteil, daß eine Messung bis zu kürzesten Entfernungen möglich ist. Außerdem kann bei einer geeigneten Ausbildung des Sensors eine lückenlose Messung über die gesamte Fahrzeugbreite durchgeführt werden. Diesen Vorteilen steht jedoch der Nachteil gegenüber, daß durch die verschiedenen Materialien, Größen und Formen der möglichen Hindernisse kein fester Zusammenhang zwischen dem Abstand und der jeweils meßbaren Kapazität besteht, also lediglich Relativwerte für den Abstand ermittelt werden.

Aus der GB 2 266 397A ist eine Fahrzeugeinparkhilfe bekannt, bei der mit Hilfe eines Ultraschallsensors der Abstand zu einem möglichen Hindernis überwacht wird. Da der Ultraschallsensor nicht alle Bereiche, insbesondere nicht den Nahbereich des Fahrzeugs erfassen kann, ist ein weiteres Meßsystem vorgesehen. Dieses Meßsystem ist als kapazitives System ausgebildet und erfaßt Hindernisse im minimalen Abstand zum Fahrzeug. Aus der Druckschrift Kramar E., ,,Funksysteme für Ortung und Navigation", 1973, Verl. Berliner Union GmbH, Stuttgart, Deutschland, S. 28 u. 29 ist ein Phasendifferenzmeßverfahren zur Messung des Abstandes von zwei Strahlerquellen A und B bekannt. Dabei senden die Strahlerquellen A und B phasensynchrone HF-Signale, die an dem Empfangsort mit einer bestimmten Phasendifferenz empfangen werden.

eine halbe Wellenlänge der verwendeten Frequenz ist, wird mit einem Grobmeßverfahren eine zusätzliche Messung durchgeführt. Aus der Kombination von Laufzeit und Phasenmeßverfahren läßt sich der Abstand zu einem Hindernis bestimmen.

Aufgabe der vorliegenden Erfindung ist es, ein Verfahren zur berührungslosen Abstandsmessung, insbesondere zur Messung des Abstandes von Hindernissen im Nahbereich von Kraftfahrzeugen anzugeben, bei welchem auch eine Messung geringer Abstandswerte möglich ist.

Diese Aufgabe wird erfindungsgemäß dadurch gelöst, daß Messungen mit einem ersten Meßverfahren vorgenommen werden, wobei in einem ersten Meßbereich Absolutwerte des jeweiligen Abstandes ermittelt werden, daß mit einem zweiten Meßverfahren in einem zweiten, sich mit dem ersten überlappenden Meßbereich Relativwerte ermittelt werden und daß Absolutwerte des ersten Meßverfahrens, die innerhalb des überlappenden Bereichs liegen, zur Kalibrierung der Relativwerte des zweiten Meßverfahrens verwendet werden.

Das erfindungsgemäße Verfahren hat den Vorteil, daß zur Abstandsmessung mit dem zweiten Meßverfahren, das an sich keine Absolutwerte ergibt, eine Kalibrierung vorgenommen wird, so daß schließlich dann doch Absolutwerte zur Verfügung stehen.

Obwohl die Durchführung des erfindungsgemäßen Verfahrens mit einer Vielzahl von Meßverfahren möglich ist, ist es besonders vorteilhaft, wenn das erste Meßverfahren auf einer Laufzeitmessung ausgestrahlter, reflektierter und wieder empfangener Wellen und das zweite Meßverfahren auf einer Messung einer elektrischen, magnetischen oder optischen Größe beruht. Vorzugsweise ist dabei vorgesehen, daß das erste Meßverfahren mit Ultraschallwellen durchgeführt wird und daß beim zweiten Meßverfahren eine von einer Elektrode und der Umgebung mit den Hindernissen gebildete Kapazität gemessen wird.

Diese Weiterbildung hat den Vorteil, daß bei einer entsprechenden über die ganze Breite des Fahrzeugs ausgedehnten Elektrode eine Messung des Abstandes ohne Lücken über die gesamte Fahrzeugbreite möglich ist.

Eine vorteilhafte Ausführungsform des erfindungsgemäßen Verfahrens besteht darin, daß ein Zusammenhang zwischen den mit dem zweiten Meßverfahren ermittelten Relativwerten und dem tatsächlichen Abstand für verschiedene Parameter in einem aus einer Vielzahl von Kennlinien bestehenden Kennfeld abgelegt ist und daß zur Kalibrierung durch Eingabe mindestens eines mit dem ersten Meßverfahren ermittelten Absolutwertes als tatsächlichen Abstand und des gleichzeitig ermittelten Relativwertes eine Kennlinie ausgewählt wird, die bei folgenden Messungen mit dem zweiten Meßverfahren angewendet wird. Dazu können die einzelnen Kennlinien durch praktische Versuche mit verschiedenen Hindernissen aufgenommen werden.

Eine andere vorteilhafte Ausführungsform besteht darin, daß ein Zusammenhang zwischen den mit dem zweiten Meßverfahren ermittelten Relativwerten, dem tatsächlichen Abstand und einem Kalibrierfaktor als Gleichung abgelegt ist und daß zur Kalibrierung durch Eingabe mindestens eines mit Hilfe des ersten Meßverfahrens ermittelten Absolutwertes als tatsächlichem Abstand und des gleichzeitig ermittelten Relativwertes der Kalibrierfaktor berechnet wird, der bei folgenden Messungen mit dem zweiten Meßverfahren angewendet wird. Bei dieser an sich vereinfachten Ausführungsform wird von einem ähnlichen Verhalten für verschiedene Hindernisse ausgegangen.

Die mit dem ersten Meßverfahren zur Kalibrierung vorgesehenen Absolutwerte können durch verschiedene Einflüsse gestört sein. Ebenso kann auch das Ausgangssignal des für das zweite Meßverfahren verwendeten Sensors von Störsignalen überlagert sein. Gemäß einer Weiterbildung des erfindungsgemäßen Verfahrens ist daher vorgesehen, daß mehrere im überlappenden Bereich liegende Absolutwerte zur Kalibrierung verwendet werden. Dabei können stark abweichende Absolutwerte unberücksichtigt bleiben.

Die häufigsten Anwendungen des erfindungsgemäßen Verfahrens ergeben sich bei der Annäherung an ein Hindernis. Dabei liegen zunächst Meßergebnisse nach dem ersten Meßverfahren vor. Wenn dann durch den geringer werdenden Abstand unter Berücksichtigung der seitlichen Lage des Hindernisses ein überlappender Meßbereich erreicht wird, folgt die Kalibrierung für das zweite Meßverfahren. Bei weiter abnehmendem Abstand liefert das erste Meßverfahren dann keine Meßwerte mehr, sondern lediglich das zweite Meßverfahren. Um bei der Kalibrierung die Anwendung falscher Absolutwerte auszuschließen, kann deshalb ferner vorgesehen sein, daß bei der Kalibrierung die zeitliche Abfolge der Absolutwerte berücksichtigt wird.

Die oben beschriebene Annäherung des Hindernisses findet jedoch nicht in jedem Fall statt, in dem der Abstand gemessen werden soll. So kommt es beispielsweise vor, daß bei abgeschalteten Sensoren ein Hindernis so nahe kommt, daß es sich beim Einschalten nicht im Meßbereich nach dem ersten Meßverfahren befindet. Dann kann auch keine Kalibrierung erfolgen. Um in möglichst allen Fällen eine auswertbare Anzeige zu erhalten, ist deshalb gemäß einer anderen Weiterbildung vorgesehen, daß bei Abständen, die außerhalb des Meßbereichs des ersten Meßverfahrens liegen, kalibrierte mit dem zweiten Meßverfahren ermittelte Relativwerte ausgegeben werden, sofern zuvor nach dem ersten Meßverfahren Absolutwerte ermittelt wurden, und daß anderenfalls unabhängig von den jeweils ermittelten Relativwerten ein Warnsignal ausgegeben wird.

Ausführungsbeispiele der Erfindung sind in der Zeichnung anhand mehrerer Figuren dargestellt und in der nachfolgenden Beschreibung näher erläutert. Es zeigt:
- Fig. 1: ein Blockschaltbild einer Einrichtung zur Durchführung des erfindungsgemäßen Verfahrens,
- Fig. 2: eine Darstellung zur Erläuterung der Grenzen des Meßbereichs nach einem bekannten Verfahren,
- Fig. 3: die Anordnung von Sensoren an einem Kraftfahrzeug zur Durchführung des erfindungsgemäßen Verfahrens,
- Fig. 4: eine Darstellung von nach dem ersten Meßverfahren ermittelten Absolutwerten in Abhängigkeit vom Abstand,
- Fig. 5: mehrere Kennlinien eines zu kalibrierenden kapazitiven Sensors und
- Fig. 6: ein Ausführungsbeispiel eines Computerprogramms zur Durchführung des erfindungsgemäßen Verfahrens.

Gleiche Teile sind in den Figuren mit gleichen Bezugszeichen versehen.

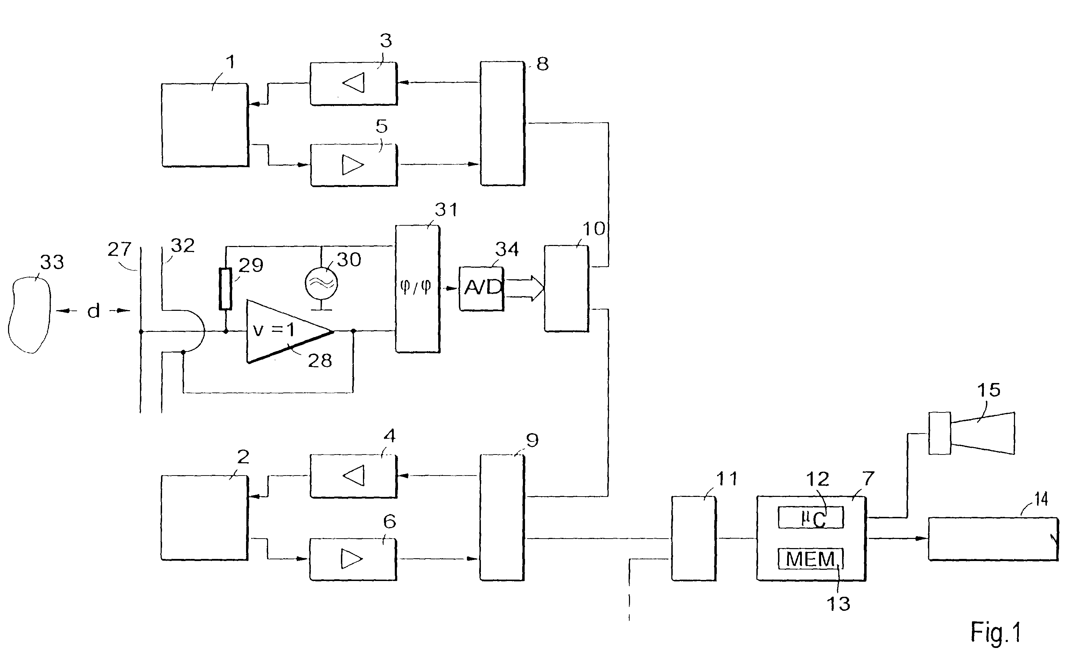

Bei der Anordnung nach Fig. 1 sind zwei Ultraschallsensoren 1, 2 vorgesehen, die jeweils über einen Verstärker 3, 4 eine Wechselspannung zum Senden erhalten und mit je einer Empfangsschaltung 5, 6 verbunden sind. Die Ultraschallsensoren 1, 2, die Verstärker 3, 4 und die Empfangsschaltungen 5, 6 sind an sich bekannt und brauchen im Zusammenhang mit der vorliegenden Erfindung nicht näher erläutert zu werden. Die Steuerung der Verstärker 3, 4 sowie die Übertragung der Ausgangssignale der Empfangsschaltungen 5, 6 erfolgen von und zu einem Steuergerät 7 mit Hilfe eines CAN-Netzwerkes (CAN = Controller Area Network), welches für jede der angeschlossenen Komponenten einen CAN-Controller 8, 9, 10, 11 aufweist. Ein solches Netzwerk ist beispielsweise in Lawrenz, W. et al.: "CAN-Controller Area Network for In-vehicle Network Applications", SAE Information Report J1583, Botzenhardt, W. et al.: "Bussystem für Kfz-Steuergeräte", VDI Berichte Nr. 612, 1986, Seiten 459 bis 470 und Lawrenz, W.: "Entwicklungswerkzeuge für Controller-Netzwerke", Elektronik 18/4.9.1987, Seiten 136 bis 140 beschrieben. Dabei sind in Fig. 1 nur diejenigen CAN-Controller dargestellt, die zur Einrichtung zur Durchführung des erfindungsgemäßen Verfahrens gehören.

Das Steuergerät 7 enthält einen Mikrocomputer 12 und zu dessen Betrieb erforderliche Speicher 13. Ein Programm für den Mikrocomputer 12 führt die einzelnen Schritte des erfindungsgemäßen Verfahrens durch. An einen Ausgang des Steuergerätes 7 ist eine Anzeigevorrichtung 14 und ein akustischer Signalgeber 15 angeschlossen.

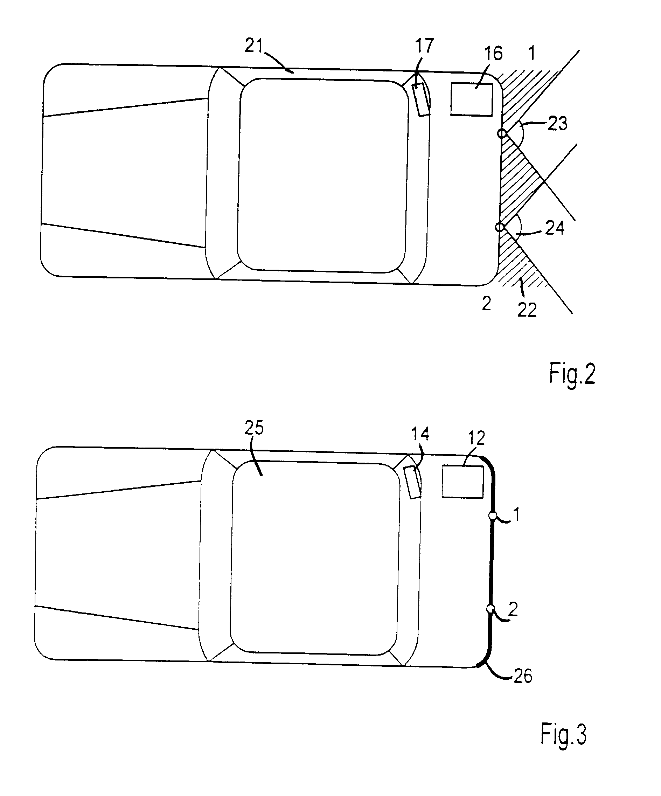

Fig. 2 zeigt schematisch ein Kraftfahrzeug 21, an dessen Heck in an sich bekannter Weise zwei Ultraschallsensoren 1, 2 angeordnet sind. Die Ultraschallsensoren 1, 2 weisen Erfassungswinkel auf, außerhalb denen die Erfassung von Hindernissen nicht möglich ist. Diese Bereiche 22 sind in Fig. 2 schraffiert gekennzeichnet. Außerdem befinden sich innerhalb der Erfassungswinkel in der Nähe der Sensoren weitere Bereiche 23, 24, in denen ebenfalls keine Entfernungsmessung möglich ist. In Fig. 2 sind ferner ein Steuergerät 16 und eine Anzeigevorrichtung 17 angedeutet.

Bei dem in Fig. 3 dargestellten zur Durchführung des erfindungsgemäßen Verfahrens ausgerüsteten Kraftfahrzeug 25 sind am Heck wiederum zwei Ultraschallsensoren 1, 2 angeordnet. Ferner erstreckt sich ein kapazitiver Sensor 26 über die gesamte hintere Stoßstange.

Der kapazitive Sensor 26 wird von einer Elektrode 27 gebildet, die mit dem Eingang eines Verstärkers 28 und über einen Widerstand 29 mit einem Sinusgenerator 30 verbunden ist. Die Ausgangsspannung des Verstärkers 28 und die Spannung des Sinusgenerators 30 werden einer Phasenvergleichsschaltung 31 zugeführt. Die Phasendifferenz ist abhängig von dem von der Elektrode 27 gegen Masse gebildeten Kondensator. Im Idealfall wird dieser Kondensator außer von der Elektrode 27 nur noch von der Umgebung hinter dem Fahrzeug mit den zu erfassenden Hindernissen als Gegenelektrode gebildet.

Da jedoch Karosserieteile, insbesondere die Stoßstange des Kraftfahrzeugs, aus konstruktiven Gründen sehr nahe an der Elektrode 27 angeordnet sind, wäre die dadurch gebildete Kapazität wesentlich größer. Um diese jedoch bezüglich ihrer Wirksamkeit zu verkleinern, ist eine Abschirmung 32 vorgesehen, die zwischen der Elektrode 27 und den leitenden Fahrzeugteilen angeordnet ist und mit einer Spannung beaufschlagt wird, welche möglichst der Spannung an der Elektrode gleich ist. Dieses wird mit einer Verstärkung von v = 1 des verstärkers 28 erreicht.

Trotz dieser Maßnahme ist die mit Hilfe der Phasenvergleichsschaltung 31 zu messende Kapazität nicht nur vom Abstand d des Hindernisses 33, sondern insbesondere auch von dessen Größe, Form und Dielektrizitätszahl abhängig. Bei größeren Entfernungen und/oder kleineren Hindernissen ist ferner die Kapazität zwischen Elektrode 27 und Fahrbahn zu berücksichtigen. Ein der Phasendifferenz entsprechendes Signal wird über einen Analog/Digital-Wandler 34 dem CAN-Controller 10 und weiter zum Steuergerät 7 geleitet.

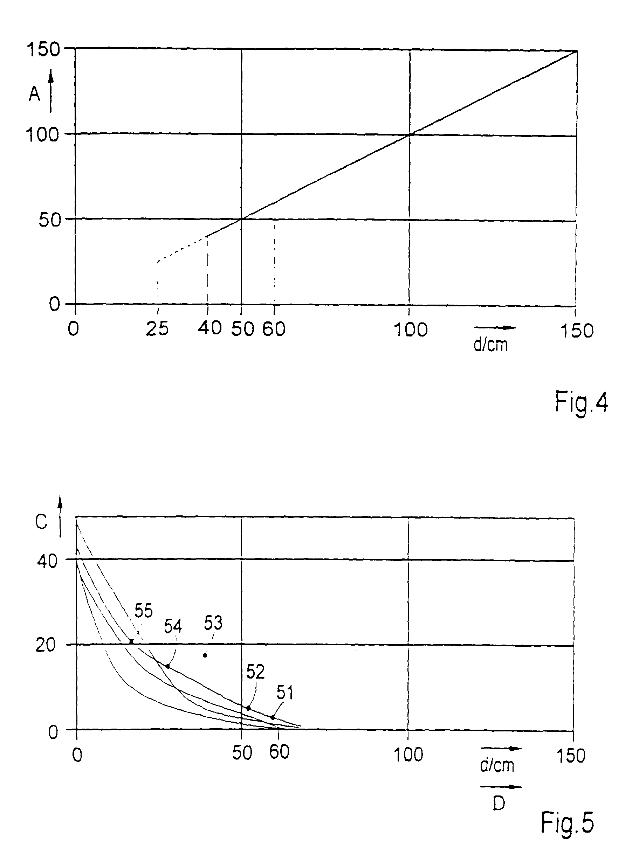

In den Figuren 4 und 5 werden die Abhängigkeiten der Ausgangssignale eines Ultraschallsensors und eines kapazitiven Sensors von der Entfernung in einem Bereich von 0 cm bis 150 cm gegenübergestellt. Dabei ist das Ausgangssignal A des Ultraschallsensors ein Absolutwert und ist in Fig. 4 als in cm geeicht dargestellt. Aus Fig. 4 ist ersichtlich, daß ein linearer Zusammenhang zwischen Ausgangssignal A und Abstand d besteht. Je nach Ausführung des Ultraschallsensors im einzelnen liegt jedoch der kleinste meßbare Abstand zwischen 25 cm und 40 cm. Das Ausgangssignal C des kapazitiven Sensors ist in Fig. 5 als Kapazitätsänderung gegenüber einer Kapazität, die bei sehr weit entferntem Hindernis gemessen wird, angegeben. Die Funktion für die Abhängigkeit von dem Abstand d entspricht in erster Näherung einer Hyperbel, kann jedoch je nach Form, Lage und Größe des Hindernisses davon abweichen.

In Fig. 5 sind gemessene Kennlinien 41 bis 44 für verschiedene Hindernisse angegeben. Dabei ist es durchaus möglich, daß sich die Kennlinien schneiden. Bei dem angegebenen Beispiel für die Kennlinien des kapazitiven Sensors kann der Meßbereich mit etwa von 0 cm bis 60 cm Abstand angegeben werden, da hier auswertbare, sich in genügender Weise von 0 unterscheidende Signale vorliegen. Die Meßbereiche der Ultraschallsensoren einerseits und des kapazitiven Sensors andererseits überlappen sich also zwischen 25 cm bis 40 cm und 60 cm. Innerhalb dieses Bereichs ist eine Kalibrierung der vom kapazitiven Sensor ermittelten Relativwerte durch die Absolutwerte der Ultraschallsensoren möglich. Die Kalibrierung kann beispielsweise dadurch erfolgen, daß eine der Kennlinien ausgewählt wird, die für die jeweils mit den Ultraschallsensoren gemessenen Abstände und die gleichzeitig vorliegenden Werte des Ausgangssignals C gilt.

Wird bei der Annäherung an ein Hindernis der Abstand kleiner als 60 cm, so werden innerhalb des Überlappungsbereichs mehrere Meßwerte der Ultraschallsensoren und des kapazitiven Sensors ausgelesen und als Eingangsgrößen des Kennfeldes gemäß Fig. 5 verwendet - nämlich die Meßwerte A der Ultraschallsensoren als Werte für den Abstand und diejenigen des kapazitiven Sensors als Ausgangssignal C. Es sei beispielhaft angenommen, daß sich damit Punkte 51, 52, 53, 54, 55 ergeben. Die Punkte 51, 52, 54, 55 liegen auf der Kennlinie 42, so daß diese für die Kalibrierung des Ausgangssignals des kapazitiven Sensors bei weiterer Annäherung des Hindernisses verwendet wird. Punkt 53 liegt zu weit von der Kennlinie entfernt, so daß der als Fehlmessung interpretiert wird. Bei der folgenden Anwendung der Kennlinie 42 zur Abstandsmessung mit dem kapazitiven Sensor wird das Ausgangssignal des Sensors bzw. die Änderung des Kapazitätswertes mit der gespeicherten Tabelle verglichen und der Abstand ausgelesen.

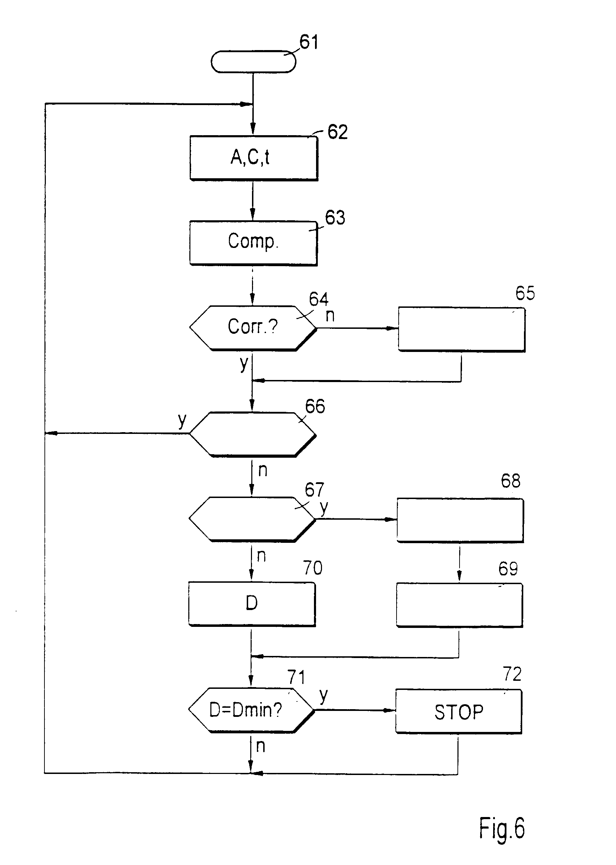

Das in Fig. 6 als Flußdiagramm dargestellte Programm für den Mikrocomputer 12 im Steuergerät 7 wird nach dem Einschalten bei 61 gestartet. In einem ersten Programmteil 62 werden die Meßwerte der beiden Ultraschallsensoren 1, 2 aufgenommen und durch Triangulation ein Absolutwert A des jeweiligen Abstandes berechnet. Außerdem wird der Kapazitätswert C aufgenommen. Die Werte A und C werden zusammen mit einer zeitangabe t in einem Speicher abgelegt. Anschließend erfolgt bei 63 eine Driftkompensation der Werte A und C. Der Einfachheit halber werden die kompensierten Werte im folgenden ebenfalls mit A und C bezeichnet. Die Driftkompensation ist beispielsweise wegen Temperaturabhängigkeiten erforderlich.

Bei 64 erfolgt eine Entscheidung in Abhängigkeit davon, ob eine Korrelation zwischen den bei 62 aufgenommenen Werten A, C und den zuvor aufgenommenen Werten - falls solche vorliegen - und den berechneten Parametern der Kalibrierung, also beispielsweise die Auswahl der Kennlinie 42, vorliegt. Besteht keine Korrelation, so ist von einer sprunghaften Veränderung gegenüber der letzten Messung auszugehen. Ein beispielsweise bei dem letzten Durchlauf des Programms nicht anwesendes Hindernis ist beim erneuten Durchlauf des Programms aufgetaucht. Für diese Fälle wird bei 65 ein Warnton ausgegeben.

Bei 66 wird geprüft, ob die Ultraschallsensoren bisher noch kein Objekt erfaßt haben. Ist dieses der Fall, wird das Programm, beginnend mit dem Programmteil 62, wiederholt. Ist dieses jedoch nicht der Fall, das heißt: haben die Ultraschallsensoren in vorangegangenen Programmdurchläufen ein Hindernis erfaßt, erfolgt eine weitere Verzweigung 67 in Abhängigkeit davon, ob die Ultraschallsensoren weiterhin ein Hindernis erfassen. Ist dieses der Fall, wird bei 68 die Ausgabe des mit Hilfe der Ultraschallsensoren gemessenen Abstandes zwischen Fahrzeug und Hindernis vorgenommen. Daraufhin wird bei 69 eine Kalibrierung durchgeführt, beispielsweise die Auswahl einer der in Fig. 5 dargestellten Kennlinien.

Wird jedoch bei 67 festgestellt, daß die Ultraschallsensoren kein Hindernis mehr erfassen, liegt der Fall vor, daß in einem der früheren Programmdurchläufe die Ultraschallsensoren ein Hindernis erfaßt haben und in dem Programmteil 69 eine Kalibrierung durchgeführt wurde. Diese Kalibrierung wird dann bei 70 zur Berechnung des mit Hilfe des kapazitiven Sensors ermittelten auszugebenden Abstandswertes D verwendet. Sowohl nach dem Programmteil 69 als auch nach dem Programmteil 70 wird bei 71 geprüft, ob das kalibrierte Signal D einen Wert Dmin erreicht hat. Ist dieses der Fall, wird bei 72 eine Warnung, beispielsweise die Anzeige des Wortes Stop ausgegeben. Ist Dmin jedoch nicht erreicht, wird ohne eine Ausgabe das Programm beginnend bei 62 wiederholt.

## Patentansprüche

1. Verfahren zur berührungslosen Abstandsmessung, insbesondere zur Messung des Abstandes von Hindernissen im Nahbereich von Kraftfahrzeugen, wobei Messungen mit einem ersten Meßverfahren sowie mit einem zweiten Meßverfahren, bei dem eine von einer Elektrode und der Umgebung mit den Hindernissen gebildete Kapazität gemessen wird, vorgenommen werden, dadurch gekennzeichnet, daß mit dem ersten Meßbereich Absolutwerte des jeweiligen Abstandes ermittelt werden, daß mit dem zweiten Meßverfahren in einem zweiten, sich mit dem ersten überlappenden Meßbereich Relativwerte ermittelt werden, daß Absolutwerte des ersten Meßverfahrens, die innerhalb des überlappenden Bereichs liegen, zur Kalibrierung der Relativwerte des zweiten Meßverfahrens verwendet werden, wobei ein Zusammenhang zwischen den mit dem zweiten Meßverfahren ermittelten Relativwerten und dem tatsächlichen Abstand für verschiedene Parameter in einem aus einer Vielzahl von aus einzelnen Meßpunkten gebildeten Kennlinien bestehenden Kennfeld abgelegt ist und daß zur Kalibrierung durch Eingabe mindestens eines mit dem ersten Meßverfahren ermittelten Absolutwertes als tatsächlichen Abstand und des gleichzeitig ermittelten Relativwertes eine Kennlinie ausgewählt wird, die bei folgenden Messungen mit dem zweiten Meßverfahren angewendet wird.

2. Verfahren nach Anspruch 1, dadurch gekennzeichnet, daß das erste Meßverfahren auf einer Laufzeitmessung ausgestrahlter, reflektierter und wieder empfangener Wellen und das zweite Meßverfahren auf einer Messung einer elektrischen, magnetischen oder optischen Größe beruht.

3. Verfahren nach Anspruch 2, dadurch gekennzeichnet, daß das erste Meßverfahren mit Ultraschallwellen durchgeführt wird.

4. Verfahren nach einem der Ansprüche 1 bis 3, dadurch gekennzeichnet, daß an Stelle des Kennfeldes ein Kalibrierfaktor mittels einer Gleichung gebildet wird und daß zur Kalibrierung durch Eingabe mindestens eines mit Hilfe des ersten Meßverfahrens ermittelten Relativwertes der Kalibrierfaktor berechnet wird, der bei folgenden Messungen mit dem zweiten Meßverfahren angewendet wird.

5. Verfahren nach Anspruch 4, dadurch gekennzeichnet, daß mehrere im überlappenden Bereich liegende Absolutwerte zur Kalibrierung verwendet werden.

6. Verfahren nach Anspruch 5, dadurch gekennzeichnet, daß stark abweichende Absolutwerte unberücksichtigt bleiben.

7. Verfahren nach einem der Ansprüche 5 oder 6, dadurch gekennzeichnet, daß bei der Kalibrierung die zeitliche Abfolge berücksichtigt wird.

8. Verfahren nach einem der vorhergehenden Ansprüche, dadurch gekennzeichnet, daß bei Abständen, die außerhalb des Meßbereichs des ersten Meßverfahrens liegen, kalibrierte mit dem zweiten Meßverfahren ermittelte Relativwerte ausgegeben werden, sofern zuvor nach dem ersten Meßverfahren Absolutwerte ermittelt wurden, und daß anderenfalls unabhängig von den jeweils ermittelten Relativwerten ein Warnsignal ausgegeben wird.

## Claims

1. Method for the contactless measurement of distance, particularly for measurement of the distance of obstacles in the vicinity of motor vehicles, measurements being taken using a first measurement method and using a second measurement method in which a capacitance formed by an electrode and the surroundings with the obstacles is measured, characterized in that the first measurement band is used to determine absolute values for the respective distance, in that the second measurement method is used to determine relative values in a second measurement band overlapping the first, in that absolute values from the first measurement method, which are within the overlapping band, are used to calibrate the relative values from the second measurement method, a relationship between the relative values determined using the second measurement method and the actual distance being stored for various parameters in a family of characteristic curves comprising a multiplicity of characteristic curves formed from individual measurement points, and in that a characteristic curve is selected for calibration by inputting at least one absolute value, determined using the first measurement method, as the actual distance and inputting the relative value determined at the same time, the said characteristic curve being used in subsequent measurements based on the second measurement method.

2. Method according to Claim 1, characterized in that the first measurement method is based on measuring the delay time of waves which are transmitted, reflected and received again, and the second measurement method is based on measuring an electrical, magnetic or optical variable.

3. Method according to Claim 2, characterized in that the first measurement method is carried out using ultrasound waves.

4. Method according to one of Claims 1 to 3, characterized in that, instead of the family of characteristic curves, a calibration factor is formed using an equation, and in that the calibration factor is calculated for calibration by inputting at least one relative value determined using the first measurement method, the said calibration factor being used in subsequent measurements based on the second measurement method.

5. Method according to Claim 4, characterized in that a plurality of absolute values which are in the overlapping band are used for calibration.

6. Method according to Claim 5, characterized in that absolute values which differ to a very great extent are not taken into account.

7. Method according to one of Claims 5 and 6, characterized in that the time sequence is taken into account during calibration.

8. Method according to one of the preceding claims, characterized in that, in the case of distances which are outside the measurement band of the first measurement method, calibrated relative values determined using the second measurement method are output if absolute values have been determined previously using the first measurement method, and in that, otherwise, a warning signal is emitted regardless of the respectively determined relative values.

## Revendications

1. Procédé de télémétrie sans contact notamment pour mesurer la distance d'obstacles à proximité de véhicules automobiles, la mesure se faisant selon un premier procédé de mesure et un second procédé de mesure à l'aide duquel on mesure la capacité formée entre une électrode et l'environnement avec les obstacles,
caractérisé en ce que
• à l'aide de la première plage de mesure, on détermine des valeurs absolues de la distance respective,
• à l'aide du second procédé de mesure, dans une seconde plage de mesure chevauchant la première plage, on détermine des valeurs relatives,
• les valeurs absolues du premier procédé de mesure, qui se situent dans la plage de chevauchement, sont utilisées pour calibrer les valeurs relatives du second procédé de mesure,
• une relation entre les valeurs relatives déterminées par le second procédé de mesure et la distance effective pour différents paramètres sont enregistrées dans un champ de caractéristiques formé d'un grand nombre de courbes caractéristique formées de points de mesure séparés pour les différents paramètres, et
• pour calibrer, par l'introduction d'au moins l'une des valeurs absolues obtenues par le premier procédé de mesure, comme distance effective et de la valeur relative déterminée simultanément, on sélectionne une courbe caractéristique utilisée au cours des mesures suivantes avec le second procédé de mesure.

2. Procédé selon la revendication 1,
caractérisé en ce que
le premier procédé de mesure repose sur une mesure de temps de parcours d'ondes émises, réfléchies et reçues de nouveau et le second procédé de mesure repose sur une mesure d'une grandeur électrique magnétique ou optique.

3. Procédé selon la revendication 2,
caractérisé en ce que
le premier procédé de mesure est effectué avec des ultrasons.

4. Procédé selon l'une des revendications 1 à 3,
caractérisé en ce qu'
à la place du champ de caractéristiques, on forme un coefficient de calibrage à l'aide d'une équation et pour calibrer, par l'introduction d'au moins une valeur relative obtenue à l'aide du premier procédé de mesure, on calcule le coefficient de calibrage utilisé au cours des mesures suivantes avec le second procédé de mesure.

5. Procédé selon la revendication 4,
caractérisé en ce qu'
on utilise plusieurs valeurs absolues situées dans la plage de chevauchement pour réaliser le calibrage.

6. Procédé selon la revendication 5,
caractérisé en ce que
les valeurs absolues qui diffèrent fortement ne sont pas prises en compte.

7. Procédé selon l'une quelconque des revendications 5 ou 6,
caractérisé en ce que
pour le calibrage, on tient compte de la succession chronologique.

8. Procédé selon l'une quelconque des revendications précédentes,
caractérisé en ce que
pour les distances situées en dehors de la plage de mesure du premier procédé de mesure, on émet des valeurs relatives calibrées obtenues par le second procédé de mesure, dans le cas où précédemment, on a déterminé des valeurs absolues par le premier procédé de mesure et en ce qu'au cas contraire, indépendamment des valeurs relatives obtenues chaque fois, on émet un signal avertisseur.
